(19)

**Europäisches Patentamt**
**European Patent Office**
**Office européen des brevets**

(11) **EP 4 787 045 A1**

# EUROPEAN PATENT APPLICATION
published in accordance with Art. 153(4) EPC

(43) Date of publication:
**05.08.2026 Bulletin 2026/32**

(21) Application number: **25764528.3**

(22) Date of filing: **28.05.2025**

(51) International Patent Classification (IPC):
***G02B 21/02*** (2006.01)

(86) International application number:
**PCT/CN2025/097700**

(87) International publication number:
**WO 2026/118395 (11.06.2026 Gazette 2026/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **05.12.2024 CN 202411779230**

(71) Applicant: **Raintree Scientific Instruments (Shanghai) Corporation**
**Shanghai 201203 (CN)**

(72) Inventors:
• **BAO, Jian**
**Shanghai 201203 (CN)**
• YANG, Haozhe
Shanghai 201203 (CN)
• ZHANG, Hao
Shanghai 201203 (CN)
• HE, Junbo
Shanghai 201203 (CN)
• XIANG, Chunchang
Shanghai 201203 (CN)

(74) Representative: **Bayramoglu et al.**
**Mira Office**
**Kanuni Sultan Süleyman Boulevard 5387**
**Street Beytepe, floor 12, no:50**
**06800 Cankaya, Ankara (TR)**

(54) **MICROSCOPE OBJECTIVE LENS FOR DEEP ULTRAVIOLET-BLUE BAND, AND DETECTION DEVICE AND METHOD**

(57)     A microscope objective lens for DUV-blue spectral range comprises a first lens group, a second catadioptric lens group, and a third catadioptric lens group. First lens group has a negative first spherical aberration, a positive first coma aberration, a negative first axial chromatic aberration, and a negative first lateral chromatic aberration. Second catadioptric lens group has a negative second spherical aberration, a positive second coma aberration, a negative second axial chromatic aberration, and a negative second lateral chromatic aberration. Third catadioptric lens group has a third spherical aberration, a third coma aberration, a third axial chromatic aberration, and a third lateral chromatic aberration. A first focal length fS1 of first lens group, a second focal length fS2 of second catadioptric lens group, a third focal length fS3 of third catadioptric lens group, and a total focal length fE1 of microscopic objective lens satisfies following formulas: |fS1/fS3|<1.5, |fS1/fS2|<1.5, and 1<|fS1/fE1|<3.

FIG.1

EP 4 787 045 A1

## Description

### TECHNICAL FIELD

The present disclosure relates to the technical field of semiconductor defect inspection, and in particular, to a microscope objective lens for a deep ultraviolet (DUV)-blue spectral range, a defect inspection system for a semiconductor device and a defect inspection method for the semiconductor device.

### BACKGROUND

As integration level of a large-scale integrated circuit becomes higher and higher, how to improve a surface defect inspection precision for a semiconductor wafer becomes an important project in an integrated circuit manufacturing process. In the prior art, a commonly used method to inspect a defect in a semiconductor device comprises an optical microscopic imaging inspection method and an electron beam inspection method. Due to a fact that a inspection speed of the former is far larger than that of the latter, thus using the optical microscopic imaging inspection method to inspect a defect in a semiconductor device has become a major method in the industry. In an inspection system based on the optical microscopic imaging method, a microscope objective lens is a most critical component, affecting directly both inspection resolution and inspection speed of the inspection system. Therefore, designing a high-quality microscope objective lens, to further improve both inspection resolution and inspection speed thereof, has an important significance for an optical microscopic imaging inspection system.

An existing patent application of CN116338924A has disclosed a microscopic imaging system with a large field of view and a high numerical aperture being able to reach a near ultraviolet (NUV)-blue spectral range (between 350nm and 550nm). However, the microscopic imaging system has a problem of having a low resolution in a DUV spectral range (for example, between 255nm and 340nm), and unable to inspect a semiconductor defect having a lower size, thus unable to meet a process requirement of inspecting a semiconductor defect at a corresponding spectral range.

In order to overcome the defects stated above in the prior art, the present disclosure provides a microscope objective lens for a DUV-blue spectral range, a defect inspection system for a semiconductor device and a defect inspection method for the semiconductor device, configured to achieve a microscopic imaging having a large field of view and a high numerical aperture in a DUV-blue spectral range, so as to meet a process requirement of semiconductor defect inspection based on the DUV spectral range.

## BRIEF SUMMARY OF THE DISCLOSURE

The following presents a simplified summary of one or more aspects to provide a basic understanding of the aspects. The present summary is not an extensive overview of all contemplated aspects, but is intended to neither identify key or critical elements of all aspects nor delineate the scope of any or all aspects. A sole purpose thereof is to present some concepts of one or more aspects in a simplified form as a prelude to the more detailed description that is presented later.

In order to overcome the defects stated above in the prior art, the present disclosure provides a microscope objective lens for a DUV-blue spectral range, an inspection system for inspecting a semiconductor device defect and a inspection method for inspecting the semiconductor device defect, being able to balance an aberration of a microscope objective lens through three lens groups, and realize microscopic imaging having a large field of view and a high numerical aperture for a DUV-blue spectral range, so as to meet the process requirement for semiconductor defect inspection based on the DUV spectral range.

Specifically, according to a first aspect, the present disclosure provides a microscope objective lens for the DUV-blue spectral range, comprising a first lens group, a second catadioptric lens group, and a third catadioptric lens group; the first lens group having a first spherical aberration being negative, a first coma aberration being positive, a first axial chromatic aberration being negative, and a first lateral chromatic aberration being negative; the second catadioptric lens group having a second spherical aberration being negative, a second coma aberration being positive, a second axial chromatic aberration being negative, and a second lateral chromatic aberration being negative; and the third catadioptric lens group having a third spherical aberration configured to compensate the first spherical aberration and the second spherical aberration, a third coma aberration configured to compensate the first coma aberration and the second coma aberration, a third axial chromatic aberration configured to compensate the first axial chromatic aberration and the second axial chromatic aberration, and a third lateral chromatic aberration configured to compensate the first lateral chromatic aberration and the second lateral chromatic aberration; wherein the first lens group, the second catadioptric lens group, and the third catadioptric lens group are satisfied with following formulas: $|fS1/fS3|<1.5$, $|fS1/fS2|<1.5$, $1<|fS1/fE1|<3$, where fS1 is a first focal length of the first lens group, fS2 is a second focal length of the second catadioptric lens group, fS3 is a third focal length of the third catadioptric lens group, and fE1 is a total focal length of the microscopic objective lens.

Further, in a plurality of embodiments of the present disclosure, the microscope objective lens further comprises a first Mangin mirror and a second Mangin mirror connected in a sequence in the third catadioptric lens group; wherein a light from an object space passes through the first Mangin mirror and reaches the second Mangin mirror, before being reflected by the second Mangin mirror and reaching the first Mangin mirror, followed by being reflected by the first Mangin mirror and passing through the second Mangin mirror, before reaching the second catadioptric lens group.

Further, in a plurality of embodiments of the present disclosure, the first Mangin mirror has a first surface with a radius of curvature of 50.04mm, a second surface with a radius of curvature of 86.47mm, and a thickness of 10.67mm; the second Mangin mirror has a first surface with a radius of curvature of 288.26mm, a second surface with a radius of curvature of 126.31mm, and a thickness of 14.24mm; an interval from the second surface of the first Mangin mirror to the first surface of the second Mangin mirror is 11.62mm.

Further, in a plurality of embodiments of the present disclosure, the microscope objective lens further comprises a third Mangin mirror, a first positive lens, a second positive lens, a first negative lens and a reflecting mirror arranged in a sequence in the second catadioptric lens group, wherein a light output by the third catadioptric lens group passes sequentially through the third Mangin mirror, the first positive lens, the second positive lens and the first negative lens, before reaching a reflecting surface of the reflecting mirror; and after being reflected by the reflecting mirror, the light then passes through the first negative lens, the second positive lens and the first positive lens, before reaching the third Mangin mirror; and after being reflected by the third Mangin mirror, the light further passes sequentially through the first positive lens, the second positive lens, the first negative lens and a through-hole at a position of an optical axis of the reflecting mirror, before reaching the first lens group.

Further, in a plurality of embodiments of the present disclosure, the third Mangin mirror has a first surface with a radius of curvature of -154.63mm, a second surface with a radius of curvature of -103.74mm, and a thickness of 24.59mm; the first positive lens has a first surface with a radius of curvature of - 47.50mm, a second surface with a radius of curvature of -50.49mm, and a thickness of 6.81mm; the second positive lens has a first surface with a radius of curvature of -67.68mm, a second surface with a radius of curvature of - 128.80mm, and a thickness of 10.13mm; the first negative lens has a first surface with a radius of curvature of 108.51mm, a second surface with a radius of curvature of -225.88mm, and a thickness of 8.05mm; the reflecting mirror has the reflecting surface with a radius of curvature of 91.02mm.

Further, in a plurality of embodiments of the present disclosure, from the first surface of the third Mangin mirror to a light emitting position of the third catadioptric lens group, there is an interval of 51.02mm; from the second surface of the third Mangin mirror to the first surface of the first positive lens, there is an interval of 0.05mm; from the second surface of the first positive lens to the first surface of the second positive lens, there is an interval of 5.43mm; from the second surface of the second positive lens to the first surface of the first negative lens, there is an interval of 10.98mm; and from the second surface of the first negative lens to the reflecting surface of the reflecting mirror, there is an interval of 13.31mm.

Further, in a plurality of embodiments of the present disclosure, the microscope objective lens further comprises a third positive lens, a fourth positive lens, a fifth positive lens, a diaphragm, a sixth positive lens, a second negative lens, a third negative lens, a seventh positive lens and an eighth positive lens arranged in a sequence in the first lens group; wherein the third positive lens extends into the through-hole at the position of the optical axis of the reflecting mirror before obtaining a light output by the second catadioptric lens group; the light passes through the third positive lens, the fourth positive lens, the fifth positive lens, an aperture of the diaphragm, the sixth positive lens, the second negative lens, the third negative lens, the seventh positive lens and the eighth positive lens sequentially before reaching an image space of the microscope objective lens.

Further, in a plurality of embodiments of the present disclosure, the third positive lens has a first surface with a radius of curvature of -19.14mm, a second surface with a radius of curvature of 35.45mm, and a thickness of 9.60mm; the fourth positive lens has a first surface with a radius of curvature of -73.44mm, a second surface with a radius of curvature of 23.02mm, and a thickness of 24.00mm; the fifth positive lens has a first surface with a radius of curvature of - 303.21mm, a second surface with a radius of curvature of 48.26mm, and a thickness of 14.32mm; the diaphragm has an aperture with a diameter of 12.95mm; the sixth positive lens has a first surface with a radius of curvature of - 44.48mm, a second surface with a radius of curvature of 96.10mm, and a thickness of 29.87mm; the second negative lens has a first surface with a radius of curvature of -23.37mm, a second surface with a radius of curvature of - 11.53mm, and a thickness of 9.81mm; the third negative lens has a first surface with a radius of curvature of 14.03mm, a second surface with a radius of curvature of 57.52mm, and a thickness of 3.91mm; the seventh positive lens has a first surface with a radius of curvature of -103.00mm, a second surface with a radius of curvature of 98.29mm, and a thickness of 3.83mm; the eighth positive lens has a first surface with a radius of curvature of -58.66 mm, a second surface with a radius of curvature of 270.10mm, and a thickness of 6.59mm..

Further, in a plurality of embodiments of the present disclosure, from the first surface of the third positive lens to the second surface of the first negative lens, there is an interval of 9.56mm; from the second surface of the third positive lens to the first surface of the fourth positive lens, there is an interval of 0.05mm; from the second surface of the fourth positive lens to the first surface of the fifth positive lens, there is an interval of 0.05mm; from the second surface of the fifth positive lens to the first surface of the diaphragm, there is an interval of 0.00mm; from the first surface of the diaphragm to the first surface of the sixth positive lens, there is an interval of 2.39mm; from the second surface of the sixth positive lens to the first surface of the second negative lens, there is an interval of 0.09mm; from the second surface of the second negative lens to the first surface of the third negative lens, there is an interval of 9.81mm; from the second surface of the third negative lens to the first surface of the seventh positive lens, there is an interval of 0.09mm; from the second surface of the seventh positive lens to the first surface of the eighth positive lens, there is an interval of 0.49mm.

In addition, according to a second aspect, the present disclosure provides an inspection system for inspecting the semiconductor device defect stated above, the inspection system comprising: the microscope objective lens for the DUV-blue spectral range provided by the first aspect of the present disclosure, wherein the object space of the microscope objective lens for the DUV-blue spectral range faces to a semiconductor device to-be-inspected; a light source configured to provide an illumination light to the semiconductor device, wherein the illumination light is located in a spectral range between 255nm and 450nm; an image acquisition module aligned with the image space of the microscope objective lens; and a controller configured to control the image acquisition module to acquire a microscopic image of the semiconductor device via the microscope objective lens, and perform a defect inspection on the semiconductor device according to the microscopic image.

In addition, according to a third aspect, the present disclosure provides a inspection method for inspecting the semiconductor device defect stated above, comprising following steps: providing an illumination light to a semiconductor device to be inspected, wherein the illumination light is located in a spectral range between 255nm and 450nm; controlling an image acquisition module to acquire a microscopic image of the semiconductor device by means of a microscope objective lens for the DUV-blue spectral range provided by the first aspect of the present disclosure; and performing defect inspection on the semiconductor device according to the microscopic image.

**BRIEF DESCRIPTION OF THE DRAWINGS**

The description of a plurality of specific embodiments of the present disclosure are briefly described hereafter, with the accompanying drawings, the above features and advantages of the present disclosure will be better understood. In the drawings, the components are not necessarily drawn to scale, and components having similar related characteristics or features may have the same or similar reference numerals.

FIG.1 illustrates a schematic diagram on an optical path of a microscope objective lens for a DUV-blue spectral range according to some embodiments of the present disclosure;

FIG.2 illustrates a graph on modulation transfer function (MTF) of an objective lens according to some embodiments of the present disclosure;

FIG.3 illustrates a graph on a wavefront error changing with a field of view according to some embodiments of the present disclosure;

FIG.4 illustrates a graph on an optical distortion according to some embodiments of the present disclosure;

FIG.5 illustrates a schematic flowchart on an inspection method for inspecting a semiconductor device defect according to some embodiments of the present disclosure.

**DETAILED DESCRIPTION**

Implementations of the present disclosure are described below by specific embodiments, and those skilled in the art can easily understand other advantages and effects of the present disclosure from the content disclosed in the present specification. Although the description of the present disclosure will be described in conjunction with a plurality of preferred embodiments, it is not intended that the features of the present disclosure are limited to the embodiments. On the contrary, the purpose of the present disclosure described in conjunction with the embodiments is to cover other options or modifications that may be extended based on the claims of the present disclosure. In order to provide a deep understanding of the present disclosure, many specific details will be included in the following description. The present disclosure may also be implemented without these details. Furthermore, in order to avoid mixing or obscuring the key points of the present disclosure, some specific details may be omitted in the description.

In the description of the present disclosure, it should be noted that, unless being expressly specified and limited otherwise, the terms "mounted", "connected to" and "connected with" should be understood in a broad sense, for example, it may be a fixed connection, a detachable connection, or an integral connection; it may be a mechanical connection or an electrical connection; and it may be a direct connection, or an indirectly connection with an intermediate medium, or a communication inside two elements. For those of ordinary skill in the art, the specific meanings of the terms stated above in the present disclosure may be understood according to a specific situation.

In addition, as used in the following description, "upper", "lower", "left", "right", "top", "bottom", "horizontal" and "vertical" should be understood as orientations shown in this section and related drawings. The relative terms are merely for ease of description, instead of representing that the apparatus described therein needs to be manufactured or operated in a specific orientation, and therefore should not be construed as limiting the present disclosure.

It should be understood that although the terms "first", "second", "third", etc. may be used herein to describe various components, regions, layers and/or portions, these components, regions, layers and/or portions should not be limited by these terms, while these terms are used merely to distinguish different components, regions, layers and/or portions. Thus, a first component, region, layer, and/or portion discussed below may be referred to as a second component, region, layer, and/or portion without departing from some embodiments of the present disclosure.

As stated above, in an inspection system based on an optical microscopic imaging method, a microscope objective lens is a most critical component, affecting directly an inspection resolution and an inspection speed. Thus designing a high-quality microscope objective lens, to further improve the inspection resolution and increase the inspection speed, has an important significance for an optical microscopic imaging inspection system. An existing patent application CN116338924A has disclosed a microscopic imaging system being able to achieve a large field of view and a high numerical aperture in an NUV-blue spectral range (between 350nm and 550nm). However, the microscopic imaging system has a low resolution in a DUV spectral range (for example, between 255nm and 450nm), and not being able to inspect a semiconductor defect having a smaller size, thus not being able to meet a process requirement for a semiconductor defect inspection in a corresponding spectral range.

According to the defects in the prior art, the present disclosure provides a microscope objective lens for a DUV-blue spectral range, an inspection system for inspecting a semiconductor device defect and a inspection method for inspecting a semiconductor device defect, being able to achieve a balance on an aberration of the microscope objective lens through three lens groups, and achieve a microscopic imaging system being able to achieve a large field of view and a high numerical aperture in a DUV-blue spectral range, so as to meet the process requirement for the semiconductor defect inspection based on the DUV spectral range.

In some non-limiting embodiments, a second aspect of the present disclosure provides an inspection system for inspecting the semiconductor device defect, comprising: a microscope objective lens for the DUV-blue spectral range provided by the first aspect of the present disclosure, a light source and an image acquisition module, wherein an object space of the microscope objective lens for the DUV-blue spectral range faces to the semiconductor device to be inspected. The light source is configured to provide an illumination light to the semiconductor device. The illumination light is located in a DUV-blue spectral range between 255nm and 450nm comprising specifically a DUV spectral range between 255nm and 350nm. And the image acquisition module is aligned with an image space of the microscope objective lens.

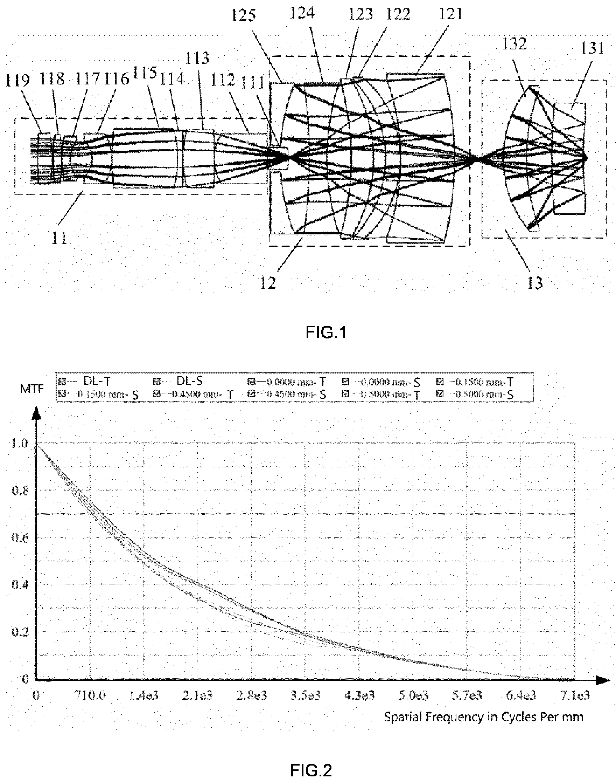

Further referencing to FIG.1, FIG.1 illustrates a schematic diagram on an optical path of the microscope objective lens for the DUV-blue spectral range according to some embodiments of the present disclosure.

In an embodiment shown as FIG.1, the microscope objective lens comprises a first lens group 11, a second catadioptric lens group 12 and a third catadioptric lens group 13. Here the first lens group 11 has a first spherical aberration being negative, a first coma aberration being positive, a first axial chromatic aberration being negative, and a first lateral chromatic aberration being negative. The second catadioptric lens group 12 has a second spherical aberration being negative, a second coma aberration being positive, a second axial chromatic aberration being negative, and a second lateral chromatic aberration being negative. The third catadioptric lens group 13 has a third spherical aberration configured to compensate the first spherical aberration and the second spherical aberration, a third coma aberration configured to compensate the first coma aberration and the second coma aberration, a third axial chromatic aberration configured to compensate the first axial chromatic aberration and the second axial chromatic aberration, and a third lateral chromatic aberration configured to compensate the first lateral chromatic aberration and the second lateral chromatic aberration.

Specifically, in the embodiment shown as FIG.1, a first focal length fS1 of the first lens group 11, a second focal length fS2 of the second catadioptric lens group 12, a third focal length fS3 of the third catadioptric lens group 13, and a total focal length fE1 of the microscopic objective lens are satisfying following three formulas: $|fS1/fS3|<1.5$, $|fS1/fS2|<1.5$, $1<|fS1/fE1|<3$.

Further, in the embodiment shown as FIG.1, from right to left, the third catadioptric lens group 13 comprises a first Mangin mirror 131 and a second Mangin mirror 132. Here, a light from the object space passes through the first Mangin mirror 131 and reaches the second Mangin mirror 132, before being reflected by the second Mangin mirror 132 and reaching the first Mangin mirror 131, followed by being reflected by the first Mangin mirror 131 and passing through the second Mangin mirror 132, before reaching the second catadioptric lens group 12.

Specifically, the first Mangin mirror 131 has a first surface (for example, a surface on right) with a radius of curvature of 50.04mm and a second surface (for example, a surface on left) with a radius of curvature of 86.47mm, and a thickness of 10.67mm. The second Mangin mirror 132 has a first surface with a radius of curvature of 288.26mm, a second surface with a radius of curvature of 126.31mm, and a thickness of 14.24mm. An interval from the second surface of the first Mangin mirror 131 to the first surface of the second Mangin mirror 132 is 11.62mm.

Preferably, in an embodiment, the first Mangin mirror 131 and the second Mangin mirror 132 have astigmatism, a field curvature and/or a distortion being mutually compensated, so as to achieve a correction to the astigmatism, the field curvature and/or the distortion independently inside the third catadioptric lens group 13.

In addition, in the embodiment shown as FIG.1, the second catadioptric lens group 12 comprises a third Mangin mirror 121, a first positive lens 122, a second positive lens 123, a first negative lens 124 and a reflecting mirror 125 arranged in a sequence. Here a light output by the third catadioptric lens group 13 passes sequentially through the third Mangin mirror 121, the first positive lens 122, the second positive lens 123 and the first negative lens 124, before reaching a reflecting surface of the reflecting mirror 125; and after being reflected by the reflecting mirror 125, the light then passes through the first negative lens 124, the second positive lens 123 and the first positive lens 122, before reaching the third Mangin mirror 121; and after being reflected by the third Mangin mirror 121, the light further passes sequentially through the first positive lens 122, the second positive lens 123, the first negative lens 124 and a through-hole at a position of an optical axis of the reflecting mirror 125, before reaching the first lens group 11.

Specifically, the third Mangin mirror 121 has a first surface with a radius of curvature of -154.63mm, a second surface with a radius of curvature of - 103.74mm, and a thickness of 24.59mm; the first positive lens 122 has a first surface with a radius of curvature of -47.50mm, a second surface with a radius of curvature of -50.49mm, and a thickness of 6.81mm; the second positive lens 123 has a first surface with a radius of curvature of -67.68mm, a second surface with a radius of curvature of -128.80mm, and a thickness of 10.13mm; the first negative lens 124 has a first surface with a radius of curvature of 108.51mm, a second surface with a radius of curvature of -225.88mm, and a thickness of 8.05mm; the reflecting mirror 125 has the reflecting surface with a radius of curvature of 91.02mm.

Wherein a radius of curvature of an optical element stated above being positive represents that a curvature is from left to right, and a radius of curvature being negative represents that a curvature is from right to left.

In addition, from the first surface of the third Mangin mirror 121 to a light emitting position of the third catadioptric lens group 13, that is, the second surface of the second Mangin mirror 132, there is an interval of 51.02mm; from the second surface of the third Mangin mirror 121 to the first surface of the first positive lens 122, there is an interval of 0.05mm; from the second surface of the first positive lens 122 to the first surface of the second positive lens 123, there is an interval of 5.43mm; from the second surface of the second positive lens 123 to the first surface of the first negative lens 124, there is an interval of 10.98mm; and from the second surface of the first negative lens 124 to the reflecting surface of the reflecting mirror 125, there is an interval of 13.31mm.

Preferably, in an embodiment, the third Mangin mirror 121, the first positive lens 122, the second positive lens 123, the first negative lens 124 and the reflecting mirror 125 have astigmatism, a field curvature and/or a distortion being mutually compensated, so as to realize a correction of the astigmatism, the field curvature and/or the distortion independently in the second catadioptric lens group 12.

In addition, in the embodiment shown as FIG.1, the first lens group 11 comprises a third positive lens 111, a fourth positive lens 112, a fifth positive lens 113, a diaphragm 114, a sixth positive lens 115, a second negative lens 116, a third negative lens 117, a seventh positive lens 118 and an eighth positive lens 119 arranged in a sequence, wherein the third positive lens 111 extends into the through-hole at the position of the optical axis of the reflecting mirror 125 before obtaining a light output by the second catadioptric lens group 12. The light passes through the third positive lens 111, the fourth positive lens 112, the fifth positive lens 113, an aperture of the diaphragm 114, the sixth positive lens 115, the second negative lens 116, the third negative lens 117, the seventh positive lens 118 and the eighth positive lens 119 sequentially before reaching the image space of the microscope objective lens.

Specifically, the third positive lens 111 has a first surface with a radius of curvature of -19.14mm, a second surface with a radius of curvature of 35.45mm, and a thickness of 9.60mm. The fourth positive lens 112 has a first surface with a radius of curvature of -73.44mm, a second surface with a radius of curvature of 23.02mm, and a thickness of 24.00mm. The fifth positive lens 113 has a first surface with a radius of curvature of -303.21mm, a second surface with a radius of curvature of 48.26mm, and a thickness of 14.32mm. The diaphragm 114 has an aperture with a diameter of 12.95mm. The sixth positive lens 115 has a first surface with a radius of curvature of -44.48mm, a second surface with a radius of curvature of 96.10mm, and a thickness of 29.87mm. The second negative lens 116 has a first surface with a radius of curvature of -23.37mm, a second surface with a radius of curvature of -11.53mm, and a thickness of 9.81mm. The third negative lens 117 has a first surface with a radius of curvature of 14.03mm, a second surface with a radius of curvature of 57.52mm, and a thickness of 3.91mm. The seventh positive lens 118 has a first surface with a radius of curvature of -103.00mm, a second surface with a radius of curvature of 98.29mm, and a thickness of 3.83mm. The eighth positive lens 119 has a first surface with a radius of curvature of -58.66 mm, a second surface with a radius of curvature of 270.10mm, and a thickness of 6.59mm.

Wherein a radius of curvature of an optical element stated above being positive represents that the curvature is from left to right, and a radius of curvature being negative represents that the curvature is from right to left.

In addition, an interval from the first surface of the third positive lens 111 to the second surface of the first negative lens 124 is 9.56mm. An interval from the second surface of the third positive lens 111 to the first surface of the fourth positive lens 112 is 0.05mm; an interval from the second surface of the fourth positive lens 112 to the first surface of the fifth positive lens 113 is 0.05mm; an interval from the second surface of the fifth positive lens 113 to the first surface of the diaphragm 114 is 0.00mm; an interval from the first surface of the diaphragm 114 to the first surface of the sixth positive lens 115 is 2.39mm; an interval from the second surface of the sixth positive lens 115 to the first surface of the second negative lens 116 is 0.09mm; an interval from the second surface of the second negative lens 116 tp the first surface of the third negative lens 117 is 9.81mm; an interval from the second surface of the third negative lens 117 to the first surface of the seventh positive lens 118 is 0.09mm; an interval from the second surface of the seventh positive lens 118 to the first surface of the eighth positive lens 119 is 0.49mm.

Preferably, in an embodiment, the third positive lens 111, the fourth positive lens 112, the fifth positive lens 113, the diaphragm 114, the sixth positive lens 115, the second negative lens 116, the third negative lens 117, the seventh positive lens 118 and the eighth positive lens 119 have astigmatism, a field curvature and/or a distortion being mutually compensated, so as to realize a correction of the astigmatism, the field curvature and/or the distortion independently in the first lens group 11.

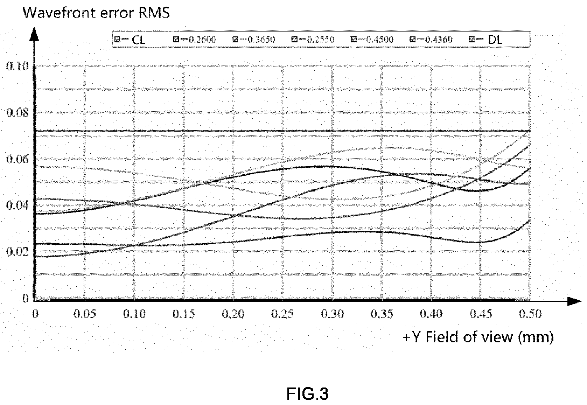

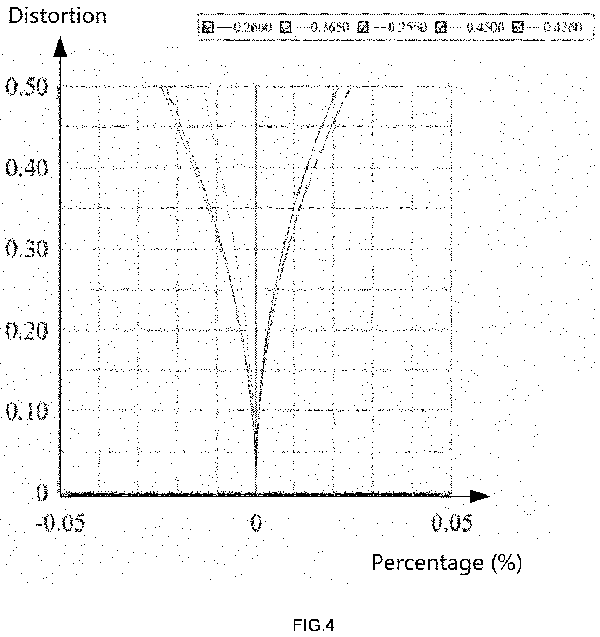

Referencing to FIG.2~FIG.4 together. FIG.2 illustrates a graph on modulation transfer function (MTF) of an objective lens according to some embodiments of the present disclosure. FIG.3 illustrates a graph on a wavefront error changing with a field of view according to some embodiments of the present disclosure. FIG.4 illustrates a graph on an optical distortion according to some embodiments of the present disclosure.

Shown as FIG.2~FIG.4, the microscope objective lens for the DUV-blue spectral range provided by the first aspect of the present disclosure has a good optical performance in the DUV-blue spectral range.

Specifically, shown as FIG.2, a modulation transfer function (MTF) of the microscope objective lens provided by the first aspect of the present disclosure is close to a diffraction limit (DL), thus having a high imaging quality. Shown as FIG.3, the microscope objective lens has all root mean square errors (RMSE) less than the diffraction limit, according to 5 wavefront errors at 255nm, 260nm, 365nm, 436nm, and 450nm. Shown as FIG.4, the microscope objective lens has a maximum optical distortion less than 0.03%, thus having a small imaging distortion.

In addition, in a plurality of embodiments, the microscope objective lens provided by the first aspect of the present disclosure has a field of view of the object space being 1mm on the DUV-blue spectral range, and a numerical aperture NA of 0.9, thus it is able to achieve a microscopic imaging having a large field of view and a high numerical aperture.

In addition, in a plurality of preferred embodiments, the inspection system for inspecting a semiconductor device defect provided by the second aspect of the present disclosure further comprises a memory and a controller. The memory has at least one computer instruction stored. The controller is connected to the memory and configured to execute the at least one computer instruction stored in the memory, so as to implement the inspection method for the semiconductor device defect provided in the third aspect of the present disclosure.

A working principle of the inspection system for inspecting the semiconductor device defect is described below, in combination with some embodiments of the inspection method for inspecting the semiconductor device defect. A person skilled in the art can understand that the embodiments of the inspection method for the semiconductor device defect are only some non-limiting embodiments provided by the present disclosure, and are intended to clearly show the main concept of the present disclosure, and provide some specific solutions for facilitating the public implementation, rather than limiting all the functions or all the working modes of the inspection system for inspecting the semiconductor device defect. Similarly, the inspection system is only a non-limiting implementation mode provided by the present disclosure, instead of limiting an execution subject and an execution sequence of each step in the inspection method.

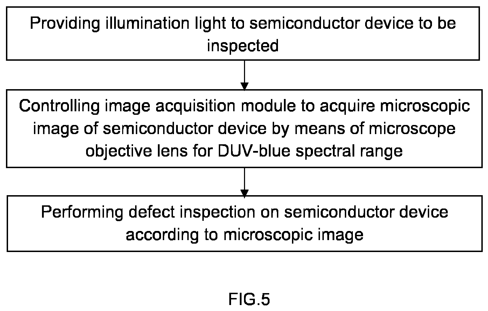

Referencing to FIG.5, FIG.5 illustrates a schematic flowchart on a inspection method for inspecting a semiconductor device defect according to some embodiments of the present disclosure.

Shown as FIG.5, the controller first provides an illumination light from a light source to a semiconductor device to be inspected, wherein the illumination light is located in a spectral range between 255nm and 450nm.

Afterwards, the controller controls an image acquisition module to acquire a microscopic image of the semiconductor device by means of the microscope objective lens for the DUV-blue spectral range provided by the first aspect of the present disclosure.

Further, the controller will then perform defect inspection on the semiconductor device according to the microscopic image.

All above, the present disclosure provides the microscope objective lens for the DUV-blue spectral range, the inspection system for inspecting the semiconductor device defect and the inspection method for inspecting the semiconductor device defect, being all able to achieve a balance on the aberration of the microscope objective lens through three lens groups, and applied to the DUV-blue spectral range before achieving a microscopic imaging having a large field of view and a high numerical aperture, so as to meet the process requirement for the semiconductor defect inspection based on the DUV spectral range. According to a definition formula of Rayleigh diffraction limit resolution:

$$d = 0.6 \times \frac{\lambda}{NA}$$ , and by achieving a microscopic imaging having a large field of view and a high numerical aperture in a DUV-blue spectral range between 255nm and 450nm, especially in a DUV spectral range between 255nm and 350nm, the present disclosure is able to further reduce a resolution size of an inspection system, so as to improve an inspection precision for the semiconductor defect.

Although the method stated above is illustrated and described as a series of actions, so as to simplify the explanation, it should be understood and appreciated that the method is not limited by an order of actions, as according to one or more embodiments, some actions may occur in a different order and/or concurrently with other actions from the illustrated and described herein or not illustrated or described herein but understood by those skilled in the art.

Although the controller described in the embodiments stated above can be implemented through a combination of software and hardware, it can be understood that the controller can also be implemented through software or hardware independently. For a hardware implementation, the controller may be implemented on a plurality of electronic devices including an application specific integrated circuit (ASIC), a digital signal processor (DSP), a programmable logic device (PLD), a field programmable gate array (FPGA), a processor, a controller, a microcontroller, a microprocessor, and more, configured to perform the functions stated above, or a selected combination of the electronic devices stated above. For a software implementation, the controller may be implemented through a plurality of independent software modules including a procedure module and a function module running on a general-purpose chip, wherein each module performs one or more of the functions and operations described in the present disclosure.

The previous description of the present disclosure is provided to enable any skilled person in the art to make or use the present disclosure. Various modifications to the present disclosure will be apparent to those skilled in the art, and a universal principle defined herein may be applied to other variants without departing from the spirit or scope of the present disclosure. Therefore, the present disclosure is not intended to be limited to the embodiments and designs described herein, but should be granted a widest scope consistent with the principles and novel features disclosed herein.

## Claims

1. A microscope objective lens for a DUV-blue spectral range, comprising:

   a first lens group having a first spherical aberration being negative, a first coma aberration being positive, a first axial chromatic aberration being negative, and a first lateral chromatic aberration being negative;
   a second catadioptric lens group having a second spherical aberration being negative, a second coma aberration being positive, a second axial chromatic aberration being negative, and a second lateral chromatic aberration being negative; and
   a third catadioptric lens group having a third spherical aberration configured to compensate the first spherical aberration and the second spherical aberration, a third coma aberration configured to compensate the first coma aberration and the second coma aberration, a third axial chromatic aberration configured to compensate the first axial chromatic aberration and the second axial chromatic aberration, and a third lateral chromatic aberration configured to compensate the first lateral chromatic aberration and the second lateral chromatic aberration;
   wherein the first lens group, the second catadioptric lens group, and the third catadioptric lens group are satisfied with following formulas:
   $|fS1/fS3|<1.5$, $|fS1/fS2|<1.5$, $1<|fS1/fE1|<3$,
   where fS1 is a first focal length of the first lens group, fS2 is a second focal length of the second catadioptric lens group, fS3 is a third focal length of the third catadioptric lens group, and fE1 is a total focal length of the microscopic objective lens.

2. The microscope objective lens according to claim 1, further comprising a first Mangin mirror and a second Mangin mirror connected in a sequence in the third catadioptric lens group; wherein a light from an object space passes through the first Mangin mirror and reaches the second Mangin mirror, before being reflected by the second Mangin mirror and reaching the first Mangin mirror, followed by being reflected by the first Mangin mirror and passing through the second Mangin mirror, before reaching the second catadioptric lens group.

3. The microscope objective lens according to claim 2, wherein

   the first Mangin mirror has a first surface with a radius of curvature of 50.04mm, a second surface with a radius of curvature of 86.47mm, and a thickness of 10.67mm;
   the second Mangin mirror has a first surface with a radius of curvature of 288.26mm, a second surface with a radius of curvature of 126.31mm, and a thickness of 14.24mm;
   an interval from the second surface of the first Mangin mirror to the first surface of the second Mangin mirror is 11.62mm.

4. The microscope objective lens according to claim 1, further comprising a third Mangin mirror, a first positive lens, a second positive lens, a first negative lens and a reflecting mirror arranged in a sequence in the second catadioptric lens group, wherein a light output by the third catadioptric lens group passes through the third Mangin mirror, the first positive lens, the second positive lens and the first negative lens in a sequence, before reaching a reflecting surface of the reflecting mirror; and after being reflected by the reflecting mirror, the light then passes through the first negative lens, the second positive lens and the first positive lens, before reaching the third Mangin mirror; and after being reflected by the third Mangin mirror, the light further passes through the first positive lens, the second positive lens, the first negative lens and a through-hole at a position of an optical axis of the reflecting mirror in a sequence, before reaching the first lens group.

5. The microscope objective lens according to claim 4, wherein

the third Mangin mirror has a first surface with a radius of curvature of - 154.63mm, a second surface with a radius of curvature of -103.74mm, and a thickness of 24.59mm; the first positive lens has a first surface with a radius of curvature of - 47.50mm, a second surface with a radius of curvature of -50.49mm, and a thickness of 6.81mm; the second positive lens has a first surface with a radius of curvature of - 67.68mm, a second surface with a radius of curvature of -128.80mm, and a thickness of 10.13mm; the first negative lens has a first surface with a radius of curvature of 108.51mm, a second surface with a radius of curvature of -225.88mm, and a thickness of 8.05mm; the reflecting mirror has the reflecting surface with a radius of curvature of 91.02mm.

6. The microscope objective lens according to claim 5, wherein

from the first surface of the third Mangin mirror to a light emitting position of the third catadioptric lens group, there is an interval of 51.02mm; from the second surface of the third Mangin mirror to the first surface of the first positive lens, there is an interval of 0.05mm; from the second surface of the first positive lens to the first surface of the second positive lens, there is an interval of 5.43mm; from the second surface of the second positive lens to the first surface of the first negative lens, there is an interval of 10.98mm; and from the second surface of the first negative lens to the reflecting surface of the reflecting mirror, there is an interval of 13.31mm.

7. The microscope objective lens according to claim 4, further comprising a third positive lens, a fourth positive lens, a fifth positive lens, a diaphragm, a sixth positive lens, a second negative lens, a third negative lens, a seventh positive lens and an eighth positive lens arranged in a sequence in the first lens group; wherein the third positive lens extends into the through-hole at the position of the optical axis of the reflecting mirror before obtaining a light output by the second catadioptric lens group; the light passes through the third positive lens, the fourth positive lens, the fifth positive lens, an aperture of the diaphragm, the sixth positive lens, the second negative lens, the third negative lens, the seventh positive lens and the eighth positive lens sequentially before reaching an image space of the microscope objective lens.

8. The microscope objective lens according to claim 7, wherein

the third positive lens has a first surface with a radius of curvature of - 19.14mm, a second surface with a radius of curvature of 35.45mm, and a thickness of 9.60mm; the fourth positive lens has a first surface with a radius of curvature of - 73.44mm, a second surface with a radius of curvature of 23.02mm, and a thickness of 24.00mm; the fifth positive lens has a first surface with a radius of curvature of - 303.21mm, a second surface with a radius of curvature of 48.26mm, and a thickness of 14.32mm; the diaphragm has an aperture with a diameter of 12.95mm; the sixth positive lens has a first surface with a radius of curvature of - 44.48mm, a second surface with a radius of curvature of 96.10mm, and a thickness of 29.87mm; the second negative lens has a first surface with a radius of curvature of - 23.37mm, a second surface with a radius of curvature of -11.53mm, and a thickness of 9.81mm; the third negative lens has a first surface with a radius of curvature of 14.03mm, a second surface with a radius of curvature of 57.52mm, and a thickness of 3.91mm; the seventh positive lens has a first surface with a radius of curvature of - 103.00mm, a second surface with a radius of curvature of 98.29mm, and a thickness of 3.83mm; the eighth positive lens has a first surface with a radius of curvature of -58.66 mm, a second surface with a radius of curvature of 270.10mm, and a thickness of 6.59mm.

9. The microscope objective lens according to claim 8, wherein

from the first surface of the third positive lens to the second surface of the first negative lens, there is an interval of 9.56mm;
from the second surface of the third positive lens to the first surface of the fourth positive lens, there is an interval of 0.05mm;
from the second surface of the fourth positive lens to the first surface of the fifth positive lens, there is an interval of 0.05mm;
from the second surface of the fifth positive lens to the first surface of the diaphragm, there is an interval of 0.00mm;
from the first surface of the diaphragm to the first surface of the sixth positive lens, there is an interval of 2.39mm;
from the second surface of the sixth positive lens to the first surface of the second negative lens, there is an interval of 0.09mm;
from the second surface of the second negative lens to the first surface of the third negative lens, there is an interval of 9.81mm;
from the second surface of the third negative lens to the first surface of the seventh positive lens, there is an interval of 0.09mm;
from the second surface of the seventh positive lens to the first surface of the eighth positive lens, there is an interval of 0.49mm.

10. An inspection system for inspecting a semiconductor device defect, comprising:

the microscope objective lens for the DUV-blue spectral range according to any one of claims 1-9, wherein an object space thereof faces to a semiconductor device to-be-inspected;
a light source configured to provide an illumination light to the semiconductor device, wherein the illumination light is located in a spectral range between 255nm and 450nm;
an image acquisition module aligned with an image space of the microscope objective lens; and
a controller configured to control the image acquisition module to acquire a microscopic image of the semiconductor device via the microscope objective lens, and perform a defect inspection on the semiconductor device according to the microscopic image.

11. A inspection method for inspecting a semiconductor device defect comprising following steps:

providing an illumination light to a semiconductor device to be inspected, wherein the illumination light is located in a spectral range between 255nm and 450nm;
controlling an image acquisition module to acquire a microscopic image of the semiconductor device by means of the microscope objective lens for the DUV-blue spectral range according to any one of claims 1-9; and
performing defect inspection on the semiconductor device according to the microscopic image.

FIG.1

FIG.2

FIG.3

FIG.4

```
┌─────────────────────────────────────────────────┐
│ Providing illumination light to semiconductor    │
│ device to be inspected                           │
└─────────────────────────────────────────────────┘
                          │
                          ▼
┌─────────────────────────────────────────────────┐
│ Controlling image acquisition module to acquire  │
│ microscopic image of semiconductor device by     │
│ means of microscope objective lens for DUV-blue  │
│ spectral range                                   │
└─────────────────────────────────────────────────┘
                          │
                          ▼
┌─────────────────────────────────────────────────┐
│ Performing defect inspection on semiconductor    │
│ device according to microscopic image            │
└─────────────────────────────────────────────────┘
```

FIG.5

## INTERNATIONAL SEARCH REPORT

| | International application No. |
|---|---|
| | **PCT/CN2025/097700** |

**A.    CLASSIFICATION OF SUBJECT MATTER**

G02B 21/02(2006.01)i

According to International Patent Classification (IPC) or to both national classification and IPC

**B.    FIELDS SEARCHED**

Minimum documentation searched (classification system followed by classification symbols)

IPC:G02B 21, G02B 17

Documentation searched other than minimum documentation to the extent that such documents are included in the fields searched

Electronic data base consulted during the international search (name of data base and, where practicable, search terms used)

CNABS; CNTXT; VEN; WPABS; ENTXT: 第一, 第1, 第二, 第2, 折反, 反射, 显微, 物镜, 焦距, first+, 1st, negative, second +, 2nd, microscop+, objective?, catadioptric, reflect+, focal, length+

**C.    DOCUMENTS CONSIDERED TO BE RELEVANT**

| Category* | Citation of document, with indication, where appropriate, of the relevant passages | Relevant to claim No. |
|---|---|---|
| PX | CN 119355940 A (RAINTREE SCIENTIFIC INSTRUMENTS (SHANGHAI) CORP.) 24 January 2025 (2025-01-24)<br>claims 1-11 | 1-11 |
| X | US 2013308181 A1 (NAKANO MASATSUGU et al.) 21 November 2013 (2013-11-21)<br>description, paragraphs 25-55, and figures 1-7 | 11 |
| X | US 2014226203 A1 (THE ARIZONA BOARD OF REGENTS ON BEHALF OF THE UNIVERSITY OF ARIZONA et al.) 14 August 2014 (2014-08-14)<br>claim 25, description, paragraphs 88-96 and 122-126, and figures 6-8C and 15 | 11 |
| X | CN 116338924 A (RAINTREE SCIENTIFIC INSTRUMENTS (SHANGHAI) CORP.) 27 June 2023 (2023-06-27)<br>description, paragraphs 19-21, and figures 1-5 | 11 |
| A | CN 211669436 U (CHANGCHUN INSTITUTE OF OPTICS, FINE MECHANICS AND PHYSICS, CHINESE ACADEMY OF SCIENCES et al.) 13 October 2020 (2020-10-13)<br>entire document | 1-11 |
| A | US 2018275387 A1 (NIKON CORP.) 27 September 2018 (2018-09-27)<br>entire document | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **04 September 2025** | **05 September 2025** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2025/097700**

| Patent document cited in search report | | | Publication date (day/month/year) | Patent family member(s) | | | Publication date (day/month/year) |
|---|---|---|---|---|---|---|---|
| CN | 119355940 | A | 24 January 2025 | None | | | |
| US | 2013308181 | A1 | 21 November 2013 | US | 8908294 | B2 | 09 December 2014 |
| | | | | JP | 2013242565 | A | 05 December 2013 |
| | | | | JP | 5675892 | B2 | 25 February 2015 |
| US | 2014226203 | A1 | 14 August 2014 | JP | 2014153719 | A | 25 August 2014 |
| | | | | JP | 6255268 | B2 | 27 December 2017 |
| | | | | US | 9329373 | B2 | 03 May 2016 |
| CN | 116338924 | A | 27 June 2023 | None | | | |
| CN | 211669436 | U | 13 October 2020 | None | | | |
| US | 2018275387 | A1 | 27 September 2018 | JP | 2018537708 | A | 20 December 2018 |
| | | | | JP | 6766872 | B2 | 14 October 2020 |
| | | | | US | 10139610 | B2 | 27 November 2018 |
| | | | | WO | 2017074908 | A1 | 04 May 2017 |

Form PCT/ISA/210 (patent family annex) (July 2022)

**EP 4 787 045 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 116338924 A